# EUROPÄISCHE PATENTSCHRIFT

(11) **EP 3 757 580 B1**
(45) Veröffentlichungstag und Bekanntmachung des Hinweises auf die Patenterteilung: **04.10.2023**
(21) Anmeldenummer: 20181388.8
(22) Anmeldetag: 22.06.2020
(51) Int. Cl.: G01R 19/10, G01R 19/20, H02H 3/33, H02H 1/00

(54) **VORRICHTUNG ZUR ERFASSUNG VON DIFFERENZSTRÖMEN IN GLEICHSTROMGESPEISTEN ELEKTRISCHEN ANLAGEN**
DEVICE FOR DETECTING DIFFERENTIAL CURRENTS IN DC-FED ELECTRICAL SYSTEMS
DISPOSITIF DE DÉTECTION DE COURANTS DIFFÉRENTIELS DANS DES INSTALLATION ÉLECTRIQUES ALIMENTÉES EN COURANT CONTINU

(30) Priorität: 25.06.2019 DE 102019117103
(43) Veröffentlichungstag der Anmeldung: 30.12.2020
(73) Patentinhaber: Doepke Schaltgeräte GmbH, 26506 Norden (DE)
(72) Erfinder: Grünebast, Günter, 26506 Norden (DE)
(74) Vertreter: Jabbusch, Matthias

(56) Entgegenhaltungen:
- EP-A2- 1 267 467
- DE-A1- 3 823 099
- DE-A1-102013 002 376
- OLIVEIRA THIAGO R: "Design of a Low-Cost Residual Current Sensor for LVDC Power Distribution Application", 2018 13TH IEEE INTERNATIONAL CONFERENCE ON INDUSTRY APPLICATIONS (INDUSCON), IEEE, 12. November 2018 (2018-11-12), Seiten 1313-1319, XP033513261, DOI: 10.1109/INDUSCON.2018.8627238 [gefunden am 2019-01-25]

## Beschreibung

Die Erfindung betrifft eine Vorrichtung zur Erfassung und Auswertung von Differenzströmen in gleichstromgespeisten elektrischen Anlagen mit wenigstens zwei Stromleitungen für zu überwachende Lastströme und mit einer Auswerteschaltung zur Auswertung von elektrischen glatten Gleichdifferenzströmen und mit einem Stromwandler zur Erfassung von glatten Gleichdifferenzströmen, durch den die Stromleitungen für die zu überwachenden Lastströme geführt sind, wobei zumindest eine Sekundärwicklung des Stromwandlers mit einer oszillierenden Schaltung zur Erfassung der glatten Gleichdifferenzströme elektrisch verbunden ist und die oszillierende Schaltung mit der zur Auswertung von glatten Gleichdifferenzströmen vorgesehenen Auswerteschaltung elektrisch verschaltet ist.

Eine Fehlerstrom-Schutzeinrichtung, auch bekannt unter der Abkürzung RCD, weist zur Erfassung von Fehlerströmen einen Stromwandler auf, durch den die zu überwachenden Stromleitungen geführt sind. Die vektorielle Summe der Ströme in den zu überwachenden Stromleitungen wird vom Stromwandler erfasst und stellt ein Maß für den Fehlerstrom dar. Dem Stromwandler ist elektrisch nachfolgend eine Auswerteschaltung mit zugeordnetem Auslöserelais angeordnet, welches bei Überschreiten eines zulässigen Fehlerstromgrenzwertes über eine Schaltmechanik ein Öffnen der in den zu überwachenden Stromleitungen angeordneten Schaltkontakte bewirkt, wodurch im Fehlerfall eine sichere Trennung einer nachfolgenden elektrischen Anlage vom versorgenden Stromnetz gewährleistet ist.

Ein Differenzstrom-Überwachungsgerät, auch bekannt unter der Abkürzung RCM, weist zur Erfassung von Differenzströmen einen Stromwandler auf, durch den die zu überwachenden Stromleitungen geführt sind. Die vektorielle Summe der Ströme in den zu überwachenden Stromleitungen wird vom Stromwandler erfasst und stellt ein Maß für den Fehlerstrom dar. Dem Stromwandler ist elektrisch nachfolgend eine Auswerteschaltung angeordnet. Die Auswerteschaltung weist zumindest einen Ausgang auf. Dieser Ausgang kann ein Signal in elektrischer, akustischer oder optischer Weise bereitstellen, wenn ein zulässiger Wert des erfassten Differenzstromes überschritten wird. Differenzstrom-Überwachungsgeräte (RCM)s werden vorrangig für Überwachungs- und nicht für Schutzzwecke eingesetzt und weisen üblicherweise keine integrierten Mittel zur Abschaltung von zu überwachenden Stromleitungen auf.

In den üblichen und weltweit verbreiteten Wechselstromsystemen werden in bekannter Weise Fehlerstrom-Schutzeinrichtungen zum Personenschutz und Schutz von elektrischen Anlagen sowie zum Brandschutz verwendet. Diese Fehlerstrom-Schutzeinrichtungen sind aufgrund einschlägiger Produktnormen und Errichtungsbestimmungen ausschließlich für die Verwendung in Wechselstromsystemen vorgesehen. Wechselstromsysteme weisen üblicherweise Netz-frequenzen von 50 Hz oder 60 Hz auf. Für spezielle Anwendungsbereiche sind auch Wechselstromsystem mit Netzfrequenzen von 200, 300 oder 400 Hz bekannt. Im Allgemeinen werden hierzu Fehlerstrom-Schutzeinrichtungen vom Typ A verwendet. Diese erfassen netzspannungsunabhängig Wechselfehlerströme und pulsierende Gleichfehlerströme der Netzfrequenz. In der Druckschrift DE 40 39 921 ist eine solche Fehlerstrom-Schutzeinrichtung offenbart. Des Weiteren sind Fehlerstrom-Schutzeinrichtungen vom Typ F bekannt, die zusätzlich Mischfrequenzen erfassen. In der Druckschrift DE 10 2011 011 984 ist eine solche Fehlerstrom-Schutzeinrichtung vom Typ F offenbart. Zur Erfassung von glatten und pulsierenden Gleichfehlerströmen sowie auch Wechselfehlerströmen unterschiedlichster Frequenzen sind allstromsensitive Fehlerstrom-Schutzeinrichtungen vom Typ B oder B+ bekannt. In der Druckschrift EP 1 267 467 ist eine allstromsensitive Fehlerstrom-Schutzeinrichtung zur Erfassung von Fehlerströmen in Wechselstromsystemen offenbart, welche es ermöglicht Wechselfehlerströme bis zu 1 MHz sicher zu erfassen. Während Wechselstromsysteme flächendeckend für Haus- und Industrieanwendungen verfügbar sind, so sind Gleichstromsysteme flächendecken derzeit gar nicht oder nur für besondere Anwendungen z.B. im Bereich der Datenverarbeitung vorhanden. Zukünftig sollen jedoch flächendeckend Gleichstromsysteme für Haus- und Industrieanwendungen geschaffen werden. Eine Schutzeinrichtung für Gleichstromsysteme ist aus folgender Veröffentlichung bekannt: OLIVEIRA THIAGO R: "Design of a Low-Cost Residual Current Sensor for LVDC Power Distribution Application", 2018, 13th IEEE INTERNATIONAL CONFERENCE ON INDUSTRY APPLICATIONS (INDUSCON), IEEE, Seiten 1313-1319, DOI:10.1109/INDUSCON.2018.8627238.

Für den zukünftigen Einsatz von Fehlerstrom-Schutzeinrichtungen in Gleichstromsystemen ist die Technische Spezifikation IEC TS 63053 bekannt. Diese Technische Spezifikation enthält Anforderungen für Fehlerstrom-Schutzeinrichtungen ausschließlich zur Verwendung in Gleichstromsystemen zur Abschaltung bzw. Trennung beim Auftreten von glatten Gleichfehlerströmen. Ein glatter Gleichfehlerstrom ist ein welligkeitsfreier Gleichfehlerstrom. Anforderungen zur Abschaltung bei Wechselfehlerströmen oder pulsierenden Gleichfehlerströmen sind jedoch für Fehlerstrom-Schutzeinrichtungen nach IEC TS 63053 nicht vorgesehen. Fehlerstrom-Schutzeinrichtungen, die für die Verwendung in reinen Gleichstromsystemen vorgesehen sind, erfordern im Gegensatz zu Fehlerstrom-Schutzeinrichtungen zur Verwendung in Wechselstromsystemen spezielle Mittel zur Abschaltung von Gleichströmen als Lastströme. Fehlerstrom-Schutzeinrichtungen für die Verwendung in Wechselstromsystemen enthalten in bekannter und einfacher Weise zur Abschaltung nur mechanische Schaltkontakte. Wird eine elektrische Verbindung in einem Wechselstromsystem mit einem elektrischen Verbrauchsmittel unterbrochen, so bildet sich zwischen den beiden getrennten leitfähigen Teilen der Verbindung ein Lichtbogen. Dieser Lichtbogen erlischt i.d.R. jedoch bei einem nächsten Stromnulldurchgang des Laststroms des Verbrauchsmittels. Bei der Unterbrechung einer elektrischen Verbindung in einem Gleichstromsystem bildet sich ebenfalls ein Lichtbogen zwischen den beiden getrennten leitfähigen Teilen der Verbindung. Jedoch bleibt dieser Lichtbogen ggf. dauerhaft bestehen, da hier kein Stromnulldurchgang erfolgt. Dieses kann zu gefährlichen Zuständen führen, da im Bereich des Lichtbogens sehr hohe Temperaturen entstehen und zu einem Brand führen können. Die elektrische Verbindung wird somit durch den bestehenden Lichtbogen nicht unterbrochen.

Mittel zur Abschaltung von Gleichströmen können beispielsweise aus einer geeigneten Kombination aus mechanischen Schaltkontakten und Halbleiterbauelementen (z.B. Transistoren) bestehen. Bei solchen Abschalteinrichtungen sind Reihen- und/oder Parallelschaltung von mechanischen Schaltkontakten und Halbleiterbauelementen im Stand der Technik bekannt. Es sind auch Ausführungen von Abschalteinrichtungen zur Abschaltung von Gleichströmen bekannt, welche nur Halbleiterbauelemente aufweisen. Eine weitere Ausführung einer Abschalteinrichtung zur Abschaltung von Gleichströmen kann so ausgeführt sein, dass zusätzlich zu den mechanischen Schaltkontakten spezielle Lichtbogenlöscheinrichtungen verwendet werden, die auch ferromagnetische Materialien enthalten können. Solche Abschalteinrichtungen können mit oder ohne Halbleiterbauelemente ausgestaltet sein.

In elektrischen Anlagen, die von Gleichstromsystemen gespeist werden, können neben ohmschen Betriebsmitteln (z.B. Heizelemente) auch getaktete Betriebsmittel verwendet werden. Getaktete Betriebsmittel sind Betriebsmittel, die z.B. Schaltnetzteile oder Frequenzumrichter enthalten. Während bei Fehlern in ohmschen Betriebsmitteln nur glatte Gleichströme als Fehlerströme auftreten können, sind bei getakteten Betriebsmitteln im Fehlerstrom auch Wechselstromanteile der Schaltfrequenz und deren Harmonischen sowie auch weitere Wechselstromanteile z.B. bei Frequenzumrichtern auch der Ausgangsfrequenz vorhanden.

Wird die für eine elektrische Gleichstromanlage vorgesehene Gleichspannung als symmetrische Spannung mit gleicher Höhe und geerdetem Mittelpunkt bereitgestellt, z.B. mit den Leitern L+, L-, M und PE, wobei PE (Schutzleiter, Erde) mit dem Mittelpunktleiter M der Spannungsquellen für L+ und L-verbunden ist, so kann im ungünstigsten Fall je nach Art und Anschluss der elektrischen Betriebsmittel, beispielsweise nur zwischen L+ und L- gar kein glatter Gleichfehlerstrom im Fehlerfall auftreten. Stattdessen fließt z.B. bei einem Isolationsfehler gegen Erde in einem getakteten Betriebsmittel (z.B. Frequenzumrichter) ein Fehlerstrom mit Wechselstromanteilen der Schalt- und Ausgangsfrequenz sowie weitere Frequenzanteile.

Wird die für eine elektrische Gleichstromanlage vorgesehene Gleichspannung aus einem Wechselspannungssystem mit nachfolgendem Gleichrichter generiert, so entsteht im Fehlerfall ein Fehlerstrom, welcher aus einem glatten Gleichfehlerstromanteil und weiteren Wechselfehlerstromanteilen unterschiedlichster Frequenz besteht.

Dieses ist jedoch nachteilig, weil eine nach der technischen Spezifikation IEC TS 63053 vorgesehene Fehlerstrom-Schutzeinrichtung nur glatte Gleichfehlerströme und keine Wechselfehlerströme erfasst. Dieses stellt eine erhebliche Lücke in der Sicherheit von Personen, Nutztieren und elektrischen Anlagen sowie beim Brandschutz dar.

Der Erfindung liegt daher die Aufgabe zugrunde, eine Vorrichtung der eingangs genannten Gattung aufzuzeigen, welche zur Verwendung in gleichstromgespeisten elektrischen Anlagen zur Erfassung und Auswertung von Fehlerströmen mit Wechselstromanteilen unterschiedlichster Frequenz sowie glatten und pulsierenden Gleichfehlerströmen geeignet ist.

Diese Aufgabe wird durch die Merkmale des Anspruchs 1 gelöst. Erfindungsgemäß ist vorgesehen, dass Mittel zur Auswertung von Differenzströmen mit Wechselanteilen unterschiedlichster Frequenz und von pulsierenden Gleichdifferenzströmen vorgesehen sind, wobei diese Mittel eine zweite Auswerteschaltung aufweisen, welche eingangsseitig zumindest mit einer Sekundärwicklung des Stromwandlers elektrisch verschaltet ist.

Die erfindungsgemäße Vorrichtung weist zumindest einen Summenstromwandler mit einer elektrisch nachfolgend angeordneten Auswerteschaltung und einem damit elektrisch verschalteten Auslöserelais und mit einer mit dem Auslöserelais mechanisch verkoppelten Schaltmechanik zum Öffnen von Schaltkontakten zum Öffnen der zu überwachenden Stromleitern auf. Der Summenstromwandler und die Auswerteschaltung bilden die erste Einrichtung zur Erfassung und Auswertung von glatten Gleichfehlerströmen aus.

In einer besonderen Weiterbildung der Erfindung ist vorgesehen, den zu erfassenden und auszuwertenden Frequenzbereich so zu erweitern, dass eine zuverlässige und sehr genaue Erfassung sowie Auswertung von Frequenzen bis zu 1 MHz möglich ist. Hierzu ist vorgesehen, dass die zu überwachenden Stromleiter durch wenigstens einen weiteren magnetischen Stromwandler geführt sind und dass der zweite Stromwandler mit dem ersten Stromwandler verschaltet ist, wobei auf dem Leitungsweg zwischen den Stromwandlern ein eine Phasendrehung des über den Leitungsweg geführten Stromes um etwa 180° bewirkendes Koppelglied angeordnet ist, das als Hochpass ausgebildet ist.

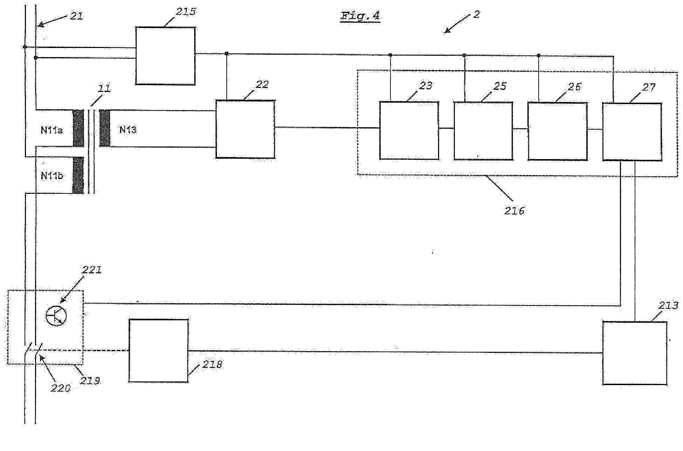

Die erfindungsgemäße Vorrichtung kann zum Schutz von Personen und elektrischen Anlagen sowie zum Brandschutz verwendet werden. Ausführungsbeispiele und Weiterbildungen der Erfindung, aus denen sich weitere erfinderische Merkmale ergeben, sind in der Zeichnung dargestellt. Die erfinderischen Merkmale werden insbesondere in den zu den Figuren 4 bis 9 aufgeführten Beschreibungen näher erläutert. Es zeigen:
- Figur 1:: Ein Gleichstromsystem mit einer Fehlerstrom-Schutzeinrichtung, einem ohmschen Verbraucher und einem Fehlerwiderstand sowie einer spektralen Darstellung des resultierenden Fehlerstroms;
- Figur 2:: Ein Gleichstromsystem mit einer Fehlerstrom-Schutzeinrichtung, einem getakteten Verbraucher und einem Fehlerwiderstand sowie einer spektralen Darstellung des resultierenden Fehlerstroms;
- Figur 3:: Ein Gleichstromsystem, welches aus einem Wechselstromsystem generiert wird, mit einer Fehlerstrom-Schutzeinrichtung, einem ohmschen Verbraucher und einem Fehlerwiderstand sowie einer spektralen Darstellung des resultierenden Fehlerstroms;
- Figur 4:: Eine aus dem Stand der Technik bekannte Fehlerstrom-Schutzeinrichtung zur Verwendung in Gleichstromsystemen;
- Figur 5:: Eine erfindungsgemäße Fehlerstrom-Schutzeinrichtung zur Verwendung in Gleichstromsystemen;
- Figur 6:: Eine Weiterbildung der erfindungsgemäßen Fehlerstrom-Schutzeinrichtung zur Verwendung in Gleichstromsystemen;
- Figur 7:: Eine Weiterbildung der erfindungsgemäßen Fehlerstrom-Schutzeinrichtung zur Verwendung in Gleichstromsystemen;
- Figur 8:: Ein erfindungsgemäßes Differenzstrom-Überwachungsgerät zur Verwendung in Gleichstromsystemen;
- Figur 9:: Eine Weiterbildung des erfindungsgemäßen Differenzstrom-Überwachungsgerätes zur Verwendung in Gleichstromsystemen.

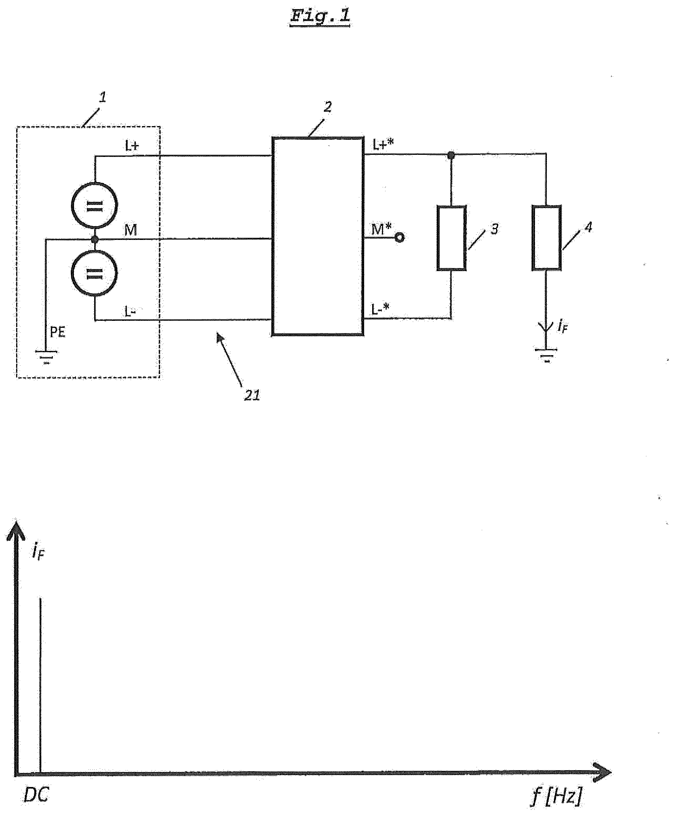

Figur 1 zeigt ein Gleichstromsystem 1, welches aus zwei Gleichspannungsquellen mit der Bezeichnung L+ und L- besteht. Der Mittelpunktleiter M ist dabei mit dem Schutzleiter PE bzw. mit der Erde verbunden. Durch die beiden Gleichspannungsquellen L+ und L- werden idealerweise zwei gleich große Gleichspannungen (z.B. 200 VDC) mit entgegengesetzter Polarität bezogen auf den Mittelpunktleiter M bereitgestellt. Im Gleichstromsystem 1 ist eine als Fehlerstrom-Schutzeinrichtung ausgeführte Schutzeinrichtung 2 vorgesehen. Die Schutzeinrichtung 2 ist eingangsseitig mit den drei zu überwachenden Stromleitungen (21) L+, L- und M verbunden. Ausgangsseitig ist die Schutzeinrichtung 2 mit den Stromleitungen L+*, L-* und M* verbunden. Ein elektrisches ohmsches Betriebsmittel 3 als Verbraucher ist mit den Stromleitungen L+* und L-* verbunden. Ein Isolationsfehler ist durch einen ohmschen Widerstand 4 dargestellt, welcher mit der Stromleitung L+* und Erde verbunden ist. Es fließt ein Fehlerstrom *i_{F}.* Bei einer Zerlegung des Fehlerstroms *i_{F}* in seine Spektralanteile ist erkennbar, dass nur ein glatter Gleichfehlerstrom DC fließt. Eine nach IEC TS 63053 ausgeführte Fehlerstrom-Schutzeinrichtung 2 wird diesen Fehlerstrom sicher erkennen und abschalten.

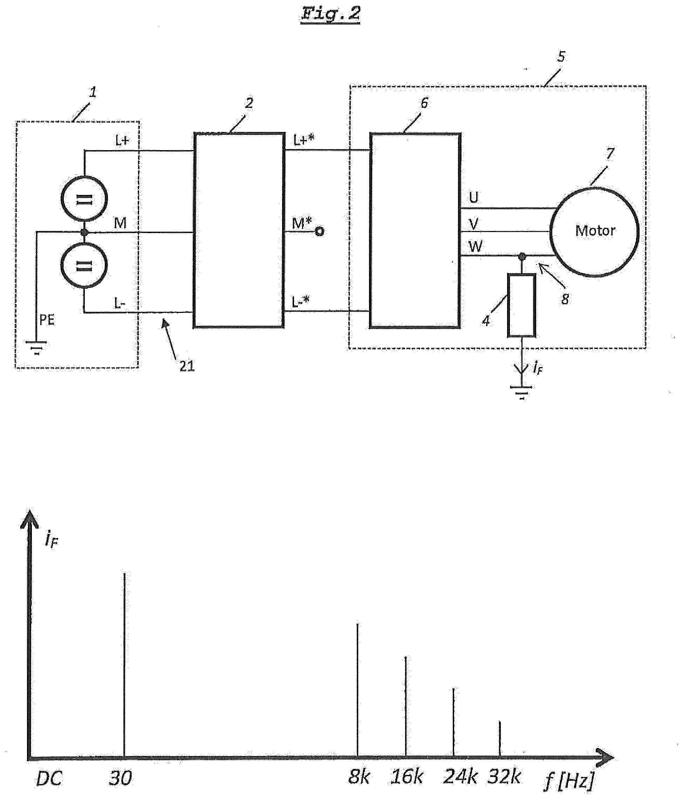

Figur 2 zeigt ein Gleichstromsystem 1, welches aus zwei Gleichspannungsquellen mit der Bezeichnung L+ und L- besteht. Der Mittelpunktleiter M ist dabei mit dem Schutzleiter PE bzw. mit der Erde verbunden. Durch die beiden Gleichspannungsquellen L+ und L- werden idealerweise zwei gleich große Gleichspannungen (z.B. 200 VDC) mit entgegengesetzter Polarität bezogen auf den Mittelpunktleiter M bereitgestellt. Im Gleichstromsystem 1 ist eine als Fehlerstrom-Schutzeinrichtung ausgeführte Schutzeinrichtung 2 vorgesehen. Die Schutzeinrichtung 2 ist eingangsseitig mit den drei zu überwachenden Stromleitungen (21) L+, L- und M verbunden. Ausgangsseitig ist die Schutzeinrichtung 2 mit den Stromleitungen L+*, L-* und M* verbunden. Ein elektrisches Betriebsmittel 5 als Verbraucher ist mit den beiden Stromleitungen L+* und L-* verbunden. Das elektrische Betriebsmittel 5 besteht aus einem Frequenzumrichter 6 und einem elektrischen Asynchronmotor 7. Frequenzumrichter 6 und Asynchronmotor 7 sind elektrisch mittels Stromleitungen U, V und W verbunden. Der Frequenzumrichter hat beispielsweise eine Schaltfrequenz von 8 kHz und eine Ausgangsfrequenz von 30 Hz. Ein Isolationsfehler 8 ist durch einen ohmschen Fehlerwiderstand 4 dargestellt, welcher mit der Stromleitung W und Erde verbunden ist. Es fließt ein Fehlerstrom *i_{F}.* Bei einer Zerlegung des Fehlerstroms *i_{F}* in seine Spektralanteile ist erkennbar, dass kein glatter Gleichfehlerstrom DC vorhanden ist. Stattdessen sind Spektralanteile der Ausgangsfrequenz und der Schaltfrequenz einschließlich mehrerer Harmonische der Schaltfrequenz zu erkennen. Neben den dargestellten signifikanten Spektralanteilen können noch weitere Spektralanteile vorhanden sein. Da eine nach IEC TS 63053 ausgeführte Fehlerstrom-Schutzeinrichtung 2 lediglich nur zur Erfassung von glatten Gleichfehlerströmen vorgesehen ist, wird die Fehlerstrom-Schutzeinrichtung 2 diesen Fehlerstrom in negativer Weise somit nicht erkennen und auch nicht abschalten.

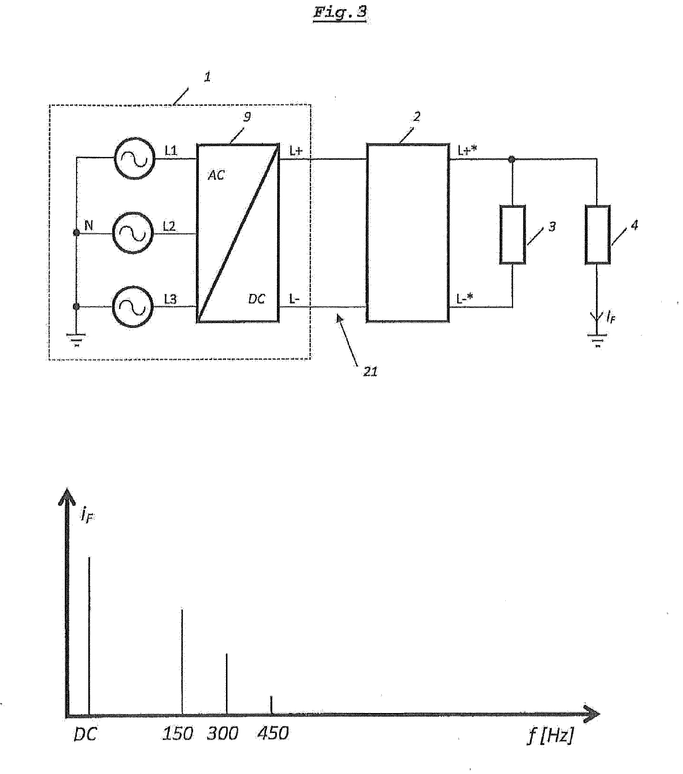

Figur 3 zeigt ein Gleichstromsystem 1, welches aus drei Wechselspannungsquellen L1, L2 und L3 generiert wird. Der gemeinsame Sternpunkt der Wechselspannungsquellen L1, L2 und L3 ist als Neutralleiter N ausgebildet und ist mit dem Schutzleiter PE bzw. mit Erde verbunden. Im Weiteren besteht das Gleichstromsystem 1 aus einem Gleichrichter 9 ohne galvanische Trennung, welcher eingangsseitig mit den Wechselspannungsquellen L1, L2 und L3 verbunden ist. Ausgangsseitig wird eine Gleichspannung an den Stromleitungen L+ und L- bereitgestellt. Alternativ kann der Gleichrichter 9 auch als Umrichter ohne galvanische Trennung ausgeführt sein. Im Gleichstromsystem 1 ist eine als Fehlerstrom-Schutzeinrichtung ausgeführte Schutzeinrichtung 2 vorgesehen. Die Schutzeinrichtung 2 ist eingangsseitig mit den beiden zu überwachenden Stromleitungen (21) L+ und L- verbunden. Ausgangsseitig ist die Schutzeinrichtung 2 mit den Stromleitungen L+* und L-* verbunden. Ein elektrisches ohmsches Betriebsmittel 3 als Verbraucher ist mit den Stromleitungen L+* und L-* verbunden. Ein Isolationsfehler ist durch einen ohmschen Widerstand 4 dargestellt, welcher mit der Stromleitung L+* und Erde verbunden ist. Es fließt ein Fehlerstrom *i_{F}.* Bei einer Zerlegung des Fehlerstroms *i_{F}* in seine Spektralanteile ist erkennbar, dass ein Anteil als glatter Gleichfehlerstrom DC fließt. Im Weiteren sind Spektralanteile mit den Frequenzen 150 Hz, 300 Hz und 450 Hz erkennbar, welche durch den Gleichrichter 9 bedingt sind. Neben den dargestellten signifikanten Spektralanteilen können noch weitere Spektralanteile vorhanden sein. Eine nach IEC TS 63053 ausgeführte Fehlerstrom-Schutzeinrichtung 2 wird diesen Fehlerstrom in negativer Weise nur teilweise erfassen, da nach IEC TS 63053 nur eine Erfassung von glatten Gleichfehlerströmen vorgesehen ist. Die Wechselfehlerstromanteile mit den Frequenzen 150 Hz, 300 Hz und 450 Hz werden nicht erfasst. Eine sichere Abschaltung im Fehlerfall ist daher nicht gewährleistet.

Figur 4 zeigt eine aus dem Stand der Technik bekannte Fehlerstrom-Schutzeinrichtung zur Verwendung in einem Gleichstromsystem. Zur Erfassung von glatten Gleichfehlerströmen weist die Fehlerstrom-Schutzeinrichtung 2 einen Stromwandler 11 auf. Die zu überwachenden Stromleitungen 21 sind als Primärwicklungen N11a und N11b durch den Stromwandler 11 geführt. Zudem weist der Stromwandler 11 zumindest eine Sekundärwicklung N13 auf. Die Sekundärwicklung N13 ist mit einer Schaltung 22 elektrisch verschaltet. Die Schaltung 22 kann dabei als eigenständige selbst oszillierende Schaltung ausgebildet sein. Im Weiteren kann die Sekundärwicklung N13 zusammen mit der Schaltung 22 als Oszillator ausgebildet sein. Der Schaltung 22 nachfolgend angeordnet ist eine Auswerteschaltung 216. Die Auswerteschaltung 216 ist in einfacher Weise so ausgeführt, dass nach der Norm IEC TS 63053 nur glatte Gleichfehlerströme erkannt werden und nur diese zur Auslösung führen. In einer möglichen Ausgestaltung kann die Auswerteschaltung 216 einen Tiefpass 23, eine Gleichrichterschaltung 25, einen weiteren Tiefpass 26 und einen Komparator 27 enthalten. Die beiden Tiefpässe 23 und 26 sind so dimensioniert, dass die Auswerteschaltung 216 nur glatte Gleichfehlerströme erkennt und nur diese zur Auslösung berücksichtigt werden. Die Ausgestaltung der Auswerteschaltung 216 mit den Komponenten 23, 25, 26 und 27 ist nur beispielhaft. Andere Ausführungen zur Ausgestaltung der Auswerteschaltung 216 sind nicht ausgeschlossen. Die Auswerteschaltung 216 ist ausgangsseitig mit einem Auslöserelais 213 verbunden. Wird eine zulässige Schwelle eines Fehlerstromes überschritten, so wird am Ausgang der Auswerteschaltung 216 ein Signal generiert. Dieses Signal bewirkt eine Auslösung des Auslöserelais 213, weil das Auslöserelais 213 mit der Auswerteschaltung 216 elektrisch verschaltet ist. Das Auslöserelais 213 ist mechanisch mit einem Schaltschloss 218 verkoppelt. Das Schaltschloss 218 bewirkt im Fehlerfall eine Öffnung der Abschalteinrichtung 219. Die Abschalteinrichtung 219 kann so ausgeführt sein, dass sie mechanische Schaltkontakte 220 enthält. Im Weiteren können in der Abschalteinrichtung 219 auch Halbleiterbauelemente 221, wie z.B. Transistoren, enthalten sein. Eine weitere Ausführung der Abschalteinrichtung 219 besteht aus einer Kombination von mechanischen Schaltkontakten 220 und Halbleiterbauelementen 221. Wenn in der Abschalteinrichtung 219 Halbleiterbauelemente 221 angeordnet sind, kann am Ausgang der Auswerteschaltung 216 ein Signal bereitgestellt werden, welches zur Steuerung der Halbleiterbauelemente 221 vorgesehen ist. Am Ausgang der Auswerteschaltung 216 kann somit ein einzelnes Signal bereitgestellt werden, welches gemeinsam zur Ansteuerung des Auslöserelais 213 und zur Ansteuerung der Halbleiterbauelemente 221 vorgesehen ist. Es kann jedoch vorteilhaft sein, eine getrennte Steuerung von Auslöserelais 213 und Halbleiterbauelementen 221 vorzusehen. In einer Ausgestaltung können daher am Ausgang der Auswerteschaltung 216 zwei Signale bereitgestellt werden, wobei ein Signal zur Ansteuerung des Auslöserelais 213 und ein Signal zur Ansteuerung der Halbleiterbauelemente 221 vorgesehen ist. Die Abschalteinrichtung 219 ist so ausgeführt, dass in den zu überwachenden Stromleitungen 21 fließende Lastströme als glatte Gleichströme zuverlässig abgeschaltet werden. Aus dem Stand der Technik sind hierzu mehrere Ausführungsformen von Abschalteinrichtungen 219 bekannt, die aus einer Kombination von mechanischen Schaltkontakten 220 und Halbleiterbauelementen 221 bestehen. Auf eine detaillierte Beschreibung und Art der Ansteuerung wird daher hier verzichtet. Aus Gründen der Übersichtlichkeit ist die Abschaltrichtung 219 in Fig. 4 und den weiter folgenden Figuren nur mit vereinfachten Schaltkontakten 220 dargestellt. Die zuvor beschriebenen Ausführungsformen mit Haltleiterbauelementen 221 sind jedoch nicht ausgeschlossen. Die Einbeziehung von Ausführungsformen von Abschalt-einrichtungen 219 mit Halbleiterbauelementen 221 ist durch das Symbol eines Transistors 221 in der Abschalteinrichtung 219 dargestellt. Eine mit den Stromleitern 21 verbundene Netzteilschaltung 215 ist zur elektrischen Versorgung mit der Schaltung 22 und mit der Auswerteschaltung 216 verbunden.

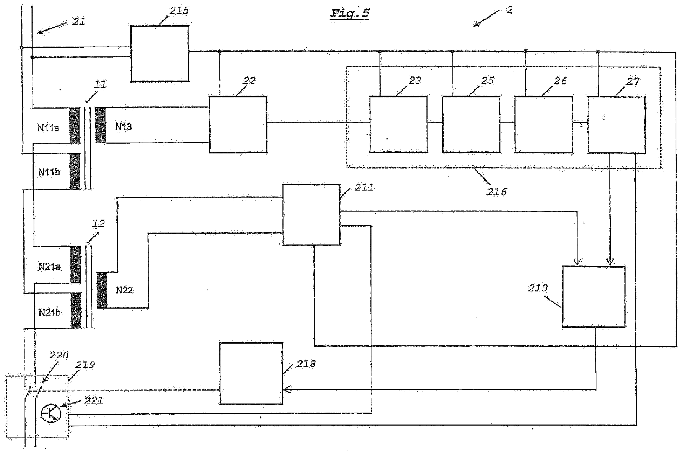

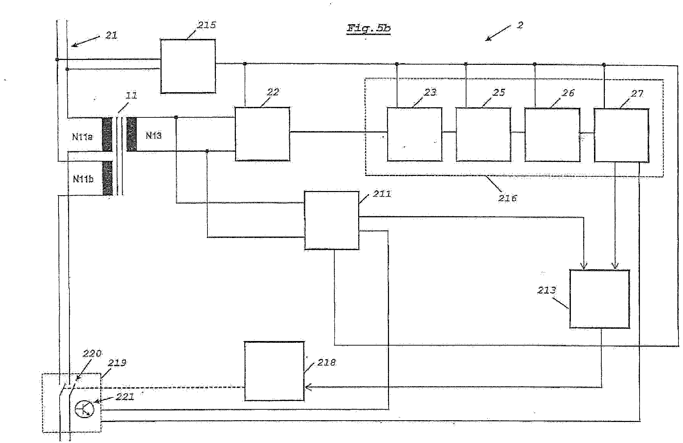

Figur 5 zeigt eine erfindungsgemäße Fehlerstrom-Schutzeinrichtung zur Verwendung in Gleichstromsystemen. In bekannter Weise ist ein erster Stromwandler 11 mit einer Schaltung 22 und einer ersten Auswerteschaltung 216 vorgesehen. Diese Schaltungsanordnung ist zur Erfassung von glatten Gleichfehlerströmen vorgesehen. Die in der ersten Auswerteschaltung 216 enthaltenen Filter 23 und 26 sind als Tiefpass ausgebildet und bilden eine Grenzfrequenz fg aus. Diese kann vorzugsweise im Bereich von 1 Hz bis 100 Hz liegen. In Abhängigkeit von der Dimensionierung der Grenzfrequenz fg können von der ersten Auswerteschaltung 216 auch Wechselfehlerströme mit sehr niedriger Frequenz unterhalb der Grenzfrequenz fg ausgewertet werden. Stromwandler 11 mit einer Schaltung 22 und einer ersten Auswerteschaltung 216 bilden somit eine erste Schaltung zur Erfassung und Auswertung von glatten Gleichfehlerströmen und Wechselfehlerströmen bis zu einer Grenzfrequenz fg aus.

In erfinderischer Weise ist ein zweiter Stromwandler 12 mit einer zweiten Auswerteschaltung 211 zur Erfassung und Auswertung von Wechselfehlerströmen größer einer Grenzfrequenz fg vorgesehen. Der zweite Stromwandler 12 ist primärseitig elektrisch in Reihe zum ersten Stromwandler 11 angeordnet. Der zweite Stromwandler 12 weist zumindest zwei Primärwicklungen N21a und N21b auf, wobei die zu überwachenden Stromleitungen 21 als Primärwicklungen N21a und N21b durch den zweiten Stromwandler 12 geführt sind. Der zweite Stromwandler 12 weist zumindest eine Sekundärwicklung N22 auf. Die Sekundärwicklung N22 ist mit dem Eingang der zweiten Auswerteschaltung 211 elektrisch verbunden. Die zweite Auswerteschaltung 211 kann in verschiedenster Weise ausgestaltet sein. Beispielsweise kann die zweite Auswerteschaltung 211 vergleichbare Komponenten wie die erste Auswerteschaltung 216 enthalten. Vorzugsweise kann am Eingang der zweiten Auswerteschaltung 211 ein Hochpassfilter angeordnet sein. Das Hochpassfilter ist so dimensioniert, dass es eine Grenzfrequenz fg ausbildet. Dem Hochpassfilter nachfolgend kann eine Komparatorschaltung angeordnet sein. Die Komparatorschaltung ist am Ausgang der zweiten Auswerteschaltung 211 angeordnet. Wird ein zulässiger Wert eines Fehlerstromes überschritten, wird zumindest ein Ausgangssignal bereitgestellt, welches mit dem Auslöserelais 213 elektrisch verbunden ist und eine Abschaltung bewirkt. In weiteren Ausgestaltungen kann die zweite Auswerteschaltung 211 beispielsweise eine Gleichrichterschaltung und einen weiteren Tiefpass zur Glättung enthalten, die eine genauere Auswertung des Fehlerstromsignals begünstigen. Zur Ansteuerung von Halbleiterbauelementen 221 in der Abschalteinrichtung 219 kann am Ausgang der zweiten Auswerteschaltung 211 ein zweites Signal bereitgestellt werden, welches mit der Abschalteinrichtung 219 elektrisch verbunden ist. Der zweite Stromwandler 12 und die zweite Auswerteschaltung 211 bilden in vorteilhafter Weise eine zweite Schaltung zur Erfassung und Auswertung von Wechselfehlerströmen größer einer Grenzfrequenz fg aus. Im Fehlerfall werden der erste Stromwandler 11 und der zweite Stromwandler 12 aufgrund ihrer primärseitigen Reihenschaltung zwangsläufig mit demselben Fehlerstrom beaufschlagt. Zur Einhaltung der Bedingungen des bekannten Abtasttheorems nach Nyquist-Shannon, können Wechselfehlerströme von der ersten Schaltung zur Erfassung und Auswertung von glatten Gleich- und Wechselfehlerströmen sicher erfasst werden, deren Frequenz maximal die Hälfte der Schwingfrequenz der als Oszillator ausgebildeten Schaltung 22 aufweist. Zur elektrischen Versorgung kann die zweite Auswerteschaltung 211 mit der Netzteilschaltung 215 verbunden sein. Üblicherweise kann die Schwingfrequenz einige kHz betragen. Mit einer so ausgeführten erfindungsgemäßen Fehlerstrom-Schutzeinrichtung 2 lassen sich in vorteilhafter Weise neben glatten Gleichfehlerströmen auch pulsierende Gleichfehlerströme und Wechselfehlerströme mit Frequenzen bis zu einigen kHz sicher erfassen.

Wie in Figur 5b dargestellt, kann in einer weiteren Ausgestaltung der erfindungsgemäßen Fehlerstrom-Schutzeinrichtung aus Figur 5 die zweite Auswerteschaltung 211 eingangsseitig parallel zur Eingangsseite der ersten Auswerteschaltung 216 verschaltet sein. Die zweite Auswerteschaltung 211 ist somit eingangsseitig mit der Sekundärwicklung N13 des ersten Stromwandlers 11 verschaltet. Auf den zweiten Stromwandler 12 kann daher in vorteilhafter Weise verzichtet werden. Auch mit einer so ausgeführten erfindungsgemäßen Fehlerstrom-Schutzeinrichtung 2 lassen sich in vorteilhafter Weise neben glatten Gleichfehlerströmen auch pulsierende Gleichfehlerströme und Wechselfehlerströme mit Frequenzen bis zu einigen kHz sicher erfassen.

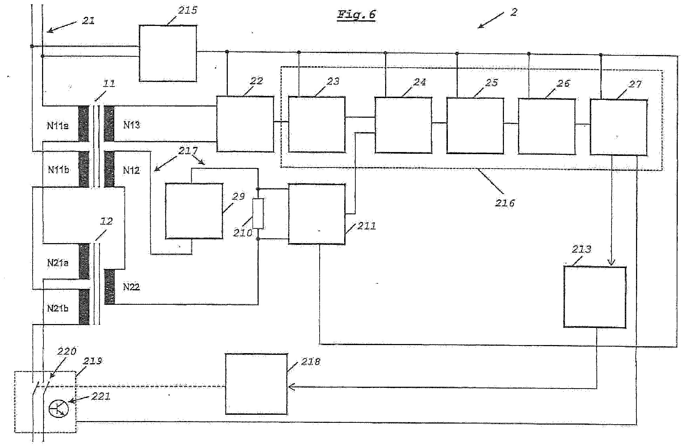

Figur 6 zeigt eine Weiterbildung der erfindungsgemäßen Fehlerstrom-Schutzeinrichtung zur Verwendung in einem Gleichstromsystem, welche zur zuverlässigen Erfassung und Auswertung von glatten und pulsierenden Gleichfehlerströmen und von Wechselfehlerströmen geeignet ist, deren Frequenzanteile größer sind als die Hälfte der Schwingfrequenz der als Oszillator ausgebildeten Schaltung 22. Aus dem Stand der Technik ist bekannt, dass beim Betrieb von elektronischen getakteten Betriebsmitteln wie z.B. Frequenzumrichtern im Fehlerfall Fehlerströme generiert werden können, die Spektralanteile der Ausgangsfrequenz und Schaltfrequenz sowie deren Oberschwingungen des getakteten Betriebsmittels enthalten. Frequenzumrichter werden üblicherweise mit Schaltfrequenzen von einigen kHz bis zu etwa 20 kHz betrieben. Figur 3 zeigt ein Gleichstromsystem mit einem Frequenzumrichter, der mit einer Schaltfrequenz von 8 kHz getaktet ist. Im Fehlerstrom sind Spektralanteile bis 32 kHz erkennbar. Bei einem Frequenzumrichter, der beispielsweise mit 20 kHz getaktet ist, sind Spektralanteile im Fehlerstrom zu erwarten die größer als 100 kHz sind.

Zur Erkennung von glatten Gleichfehlerströmen sowie Wechselfehlerströmen verschiedener Form, welche nach dem Induktionsprinzip nicht erfasst werden können, wird eine Erfassung nach dem Prinzip der gesteuerten Induktivität im ersten Stromwandler 11 vorgenommen. Um sicherzustellen, dass hierbei die Abtastbedingung nach Nyquist-Shannon nicht durch Differenzstromanteile zu hoher Frequenzen verletzt wird, werden diese Stromanteile von dem zweiten Stromwandler 12 auf die Wicklung N12 des ersten Stromwandlers 11 gegengekoppelt, so dass sie magnetisch nur noch stark gedämpft im Kern des ersten Stromwandlers 11 wirksam werden. Die Wicklungen N12 und N22 haben zu diesem Zweck vorzugsweise gleiche Windungszahlen und der zweite Stromwandler 12 hat einen Kern mit einem wesentlich größeren Induktivitätsfaktor als der Kern des ersten Stromwandlers 11. Hierdurch wirkt der zweite Stromwandler 12 über seine Wicklung N22 auf die Wicklung N12 als Stromquelle, so dass der Vormagnetisierungsstrom nicht vom ersten Stromwandler 11 auf den zweiten Stromwandler 12 übertragen wird. Ein Koppelglied 29 im Gegenkopplungsstromkreis 217 bestimmt dabei allein oder zusammen mit den Induktivitäten der Wicklungen N12 und N22 die Amplituden / Frequenz - Charakteristik des gegengekoppelten Stromes. Stromanteile mit Frequenzen f > f_{g} < 1/2*f_{T}, die eine fehlerfreie Modulation des Trägersignals f_{T} mit den niedrigen Differenzstromfrequenzen f > f_{g} im ersten Stromwandler 11 stören, werden somit aus dem Differenzstromspektrum vorteilhaft entfernt. Das Trägersignal f_{T} ist die von der Schaltung 22 generierte Schwingfrequenz. Bei einer Nichtbeachtung des Abtasttheorems nach Nyquist-Shannon treten in unvorteilhafter Weise als Aliasing bekannte Artefakte auf. Hierbei können Frequenzanteile als Artefakte entstehen, die eine zuverlässige Erfassung von Fehlerströmen über einen weiten Frequenzbereich nicht mehr ermöglichen.

Die in Fig. 5 dargestellte Fehlerstrom-Schutzeinrichtung wird nun dahingehend in Fig. 6 weiter verbessert, dass der Erfassungsfrequenzbereich des Differenzstromes bis zu sehr hohen Frequenzen, d.h. bis in den MHz-Bereich, erweitert wird. Dazu ist ein Strommesswiderstand 210 im Gegenkopplungsstromkreis 217 vorgesehen. An dem Strommesswiderstand 210 ist eine dem Gegenkopplungsstrom proportionale Spannung abgreifbar und der zweiten Auswerteschaltung 211 zuführbar. Der Ausgang der zweiten Auswerteschaltung 211 ist in vorteilhafter Weise mit einem Eingang des Summierverstärkers 24 der ersten Auswerteschaltung 216 elektrisch verbunden. Aus dem Stand der Technik ist bekannt, dass insbesondere im höherfrequenten Bereich kurzzeitige Störanteile im Differenzstrom auftreten können, die unerwünschte Auslösungen von Fehlerstrom-Schutzeinrichtungen bewirken können. Die zweite Auswerteschaltung 211 kann daher in einer einfachen und vorteilhaften Ausgestaltung eine Verzögerungsschaltung zur Ansprechverzögerung der höherfrequenten Fehlerstromspektralanteile aufweisen. Dadurch wird verhindert, dass sich höherfrequente kurzzeitige Störanteile im Fehlerstrom negativ auf das Auslöseverhalten der Fehlerstrom-Schutzeinrichtung auswirken.

Da der Gegenkopplungsstrom die oberen Frequenzanteile des Differenzstromes mit dem Amplituden / Frequenz - Verlauf enthält, die im ersten Stromwandler 11 aufgrund der Gegenkopplung ausgelöscht wurden, lassen sich die in beiden Signalwegen, die als Eingangssignale des Summierverstärkers 24 ausgebildet sind, übertragenen Frequenzspektren nach einer Verstärkungsanpassung im Summierverstärker 24 in idealer Weise wieder vollständig zu dem ursprünglichen Gesamtfrequenzspektrum des Differenzstromes addieren, was einem glatten Frequenzgang des Ansprechstromes einer Fehlerstrom-Schutzeinrichtung entspricht.

Weiterhin ist vorgesehen, dass der erste Stromwandler 11 mit nur einer Sekundärwicklung N13 und der Schaltung 22 Bestandteil einer modulierenden Schwingschaltung ist, wodurch eine einfache Wechsel-Vormagnetisierung des ersten Stromwandlers 11 mit einem Wechselstrom einer hohen Trägerfrequenz f_{T} (Schwingfrequenz) ermöglicht wird. Auf den Einsatz eines separaten Frequenzgenerators mit nachfolgenden Filterstufen kann vorteilhaft verzichtet werden.

Eine Weiterbildung der Erfindung sieht vor, dass die aus einer Schaltung 22 und der Wicklung N13 gebildete modulierende Schwingschaltung einfach und kostengünstig als Rechteckgenerator (Multivibrator) gestaltbar ist. Vorteilhaft kann zum Erreichen einer hohen Trägerfrequenz f_{T} der Kern des ersten Stromwandlers 11 aus einem verlustarmen nanokristallinen oder amorphen Werkstoff mit kleinem Induktivitätsfaktor bestehen. Durch den die Wicklung N13 des ersten Stromwandlers 11 durchfließenden Wechselstrom stellt sich in dessen Kern ein wechselmagnetisierender Zustand ein. Wird der erste Stromwandler 11 von keinem weiteren Strom durchflutet, so ist das Ausgangssignal des Rechteckgenerators ein Rechtecksignal mit einem Puls-Pausenverhältnis von 1:1. Wird der Kern des ersten Stromwandlers 11 jedoch zusätzlich durch einen Differenzstrom, d.h. durch eine Differenz der zu überwachenden Lastströme in den primären Wicklungen N11a und N11b magnetisiert, so beeinflusst dieser Differenzstrom den wechselmagnetischen Zustand, welcher dem Verlauf des Differenzstromes entsprechend eine augenblickliche Veränderung der Induktivität der Wicklung N13 zur Folge hat. Damit ändert sich das Puls-Pausenverhältnis der Rechteckgeneratorschwingung. Die Schwingung des Rechteckgenerators dient somit als Trägerfrequenz f_{T} und wird also vom Differenzstrom im Puls-Pausenverhältnis moduliert. Bevorzugt ist vorgesehen, dass dem die Schaltung 22 bildenden Rechteckgenerator nachfolgend zur Demodulation zumindest ein Tiefpassfilter 23 im Leitungsweg angeordnet ist. Um die Trägerfrequenz f_{T} ausreichend zu unterdrücken, ist das Tiefpassfilter 23 beispielsweise als aktives Filter höherer Ordnung mit einer großen Steilheit im Sperrbereich und einer Grenzfrequenz deutlich unterhalb der Trägerfrequenz f_{T} ausgebildet. Am Ausgang des Tiefpassfilters 23 wird somit nur das Abbild des Fehlerstromes erhalten und einer weiteren Auswertung zugeführt.

Bevorzugt weist die Auswerteeinrichtung 216 unter anderem zum Auswerten der Signale des unteren Frequenzspektrums aus dem Tiefpass 23 und der höherfrequenten, vom Gegenkopplungsstrom abgeleiteten Signale, einen Summierverstärker 24 mit nachfolgendem Zweiweggleichrichter 25 auf. Der Summierverstärker 24 ermöglicht, dass die bei der erfindungsgemäßen Vorrichtung auf zweifache Weise erfassten Differenzstromspektren durch unterschiedliche Verstärkung verschiedenen Bemessungsdifferenzströmen zugeordnet werden können. Beispielsweise werden zur Realisierung eines Personenschutzes mit einem DC-Bemessungsdifferenzstrom von 80 mA und einer maximalen Auslöseschwelle von 30 mA bei 50 Hz, wie für Fehlerstrom-Schutzeinrichtungen in Wechselstromsystemen bekannt, von dem ersten Stromwandler 11 nur Differenzstromspektralanteile von 0 bis etwa 100 Hz separiert, während aus dem aus der Stromgegenkopplung generierten Signal weitere Differenzstromspektralanteile bis in den MHz-Bereich erfasst und beispielsweise zur Realisierung eines Brandschutzes einem Bemessungsdifferenzstrom von 300 mA zugeordnet werden.

Weiterhin ist vorgesehen, dass dem Zweiweggleichrichter 25 zumindest eine Komparatorschaltung 27 als Bestandteil der Auswerteeinrichtung 216 nachgeordnet ist. Im Leitungsweg zwischen dem Summierverstärker 24 und der Komparator-schaltung 27 kann dabei ein Tiefpassfilter 26 angeordnet sein, mit dem eine Grenzfrequenz so eingestellt wird, dass der nachfolgende Komparator auch auf Amplituden von z.B. 50 Hz Pulsdifferenzstromsignalen innerhalb der in den einschlägigen Normen geforderten Grenzen anspricht.

Die Komparatorschaltung 27 weist vorzugsweise zwei nacheinander geschaltete Komparatoren auf, wobei dem zweiten Komparator ein Tiefpassfilter zugeordnet ist. Der zweite Komparator mit dem Tiefpassfilter dient dazu, dass die erfindungsgemäße Vorrichtung bei kurzen transienten Differenzströmen nicht anspricht. Weiterhin wird mit der Tiefpassschaltung eine Verzögerung erreicht, welche ein Ansprechen erst bei der maximal zulässigen Auslösezeit bewirkt. Dadurch erhöht sich die Störsicherheit der erfindungsgemäßen Vorrichtung. Es können somit Ansprechzeiten eingestellt werden, die der erfindungsgemäßen Vorrichtung eine Eigenschaft als zeitselektive Differenzstrom-Schutzeinrichtung geben. Schließlich kann die Auswerteschaltung 216 mit wenigstens einem Auslöserelais 213 verknüpft sein, das bei Vorlage eines unzulässigen Differenzstromes über ein Schaltschloss 218 bewirkt, dass die Abschalteinrichtung 219 den Leitungsweg des Laststromes unterbricht. Zudem kann vorgesehen sein, dass die Auswerteschaltung 216 ausgangsseitig unmittelbar mit der Abschalteinrichtung 219 zur Steuerung von Halbleiterbauelementen 221, die in der Abschalteinrichtung 219 in den zu überwachenden Stromleitungen 21 angeordnet sind, verknüpft ist. Mit einer in Figur 6 dargestellten Fehlerstrom-Schutzeinrichtung zur Verwendung in einem Gleichstromsystem ist in vorteilhafter Weise eine zuverlässige Erfassung und Auswertung von Fehlerströmen mit Wechselanteilen bis ca. 1 MHz möglich, die durch, wie in Figur 3 dargestellte, elektronische getaktete Betriebsmittel wie z.B. Frequenzumrichter generiert werden können, wobei diese Erfassung und Auswertung frei von störenden Frequenzanteilen ist, die entstehen könnten, wenn das Abtasttheorem nach Nyquist-Shannon verletzt würde.

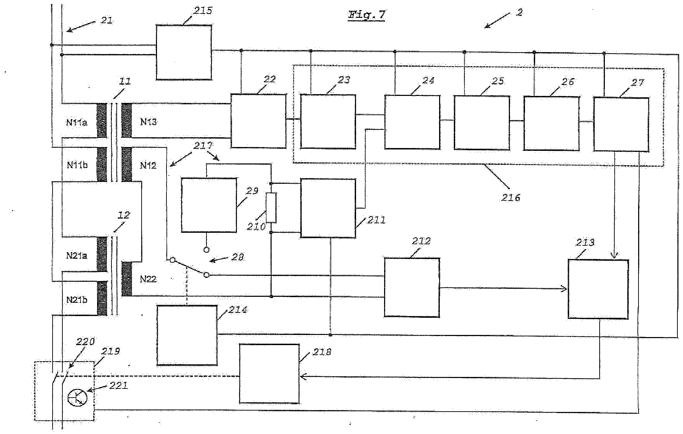

Figur 7 zeigt eine Weiterbildung der Erfindung, wobei die erfindungsgemäße Fehlerstrom-Schutzeinrichtung in vorteilhafter Weise in einem Gleichstromsystem oder in einem herkömmlichen Wechselstromsystem verwendet werden kann. Die erfindungsgemäße Fehlerstrom-Schutzeinrichtung weist eine hilfsspannungs-unabhängige Anpassschaltung 212 auf. Das Auslöserelais 213 ist mit den Sekundärwicklungen N22, N12 der beiden Stromwandler 11 und 12 verknüpfbar, wobei die Verknüpfung über einen Schaltkontakt 28 vorgenommen ist, welcher von zumindest einem Unterspannungsdetektor 214 in schaltender Weise beaufschlagt ist. Der Schaltkontakt 28 kann elektromechanisch oder in elektronischer Art mit Hilfe von Halbleitern ausgeführt sein. Die erfindungsgemäße Vorrichtung ist dadurch auch in einem Unterspannungsbereich hilfsspannungsunabhängig wie eine herkömmliche Fehlerstrom-Schutzeinrichtung zur Erfassung von Differenzströmen in einem eingeschränkten Frequenzbereich einsetzbar. Liegt die für die hilfsspannungs-abhängigen Baugruppen der erfindungsgemäßen Vorrichtung erforderliche Netzspannung unterhalb eines definierten Wertes, so werden den Sekundärwicklungen N22, N12 der beiden Stromwandler 11 und 12 direkt mit der Erregerspule des Auslöserelais 213 verschaltet. Der Schaltkontakt 28 stellt die leitende Verbindung zwischen diesen Bauelementen her.

Vorzugsweise ist vorgesehen, dass im Leitungsweg zwischen Schaltkontakt 28 und Auslöserelais 213 eine elektrische Anpassschaltung 212 angeordnet ist. Liegt die Spannung unterhalb eines definierten Wertes, beispielsweise unterhalb von 50V, so verbindet der Schaltkontakt 28 die elektrisch in Reihe miteinander verschaltete Sekundärwicklung N22 des zweiten Stromwandlers 12 und einer zweiten Sekundärwicklung N12 des ersten Stromwandlers 11 mit dieser elektrischen Anpassschaltung 212. Diese bildet in Verbindung mit den Induktivitäten beider Stromwandler 11 und 12 und dem Auslöserelais 213 einen Reihen- und Parallelschwingkreis aus, welcher in bekannter Weise zur Erfassung von Wechsel- und Pulsdifferenzströmen einsetzbar ist. Liegt die Spannung oberhalb eines definierten Wertes, so schaltet der Schaltkontakt 28 und stellt eine leitende Verbindung zwischen der Sekundärwicklung N12 und dem in Reihe zum Koppelglied 29 angeordneten Strommesswiderstand 210 her. Eine nach dieser Weiterbildung ausgestaltete Fehlerstrom-Schutzeinrichtung kann somit in vorteilhafter Weise in einem Gleichstromsystem verwendet werden.

In einer besonderen Ausgestaltung der Erfindung ist vorgesehen, dass das Koppelglied 29 in einfachster Weise als elektrisch leitender Draht oder ohmscher Widerstand ausgeführt ist, der zusammen mit den Induktivitäten der Sekundärwicklungen N12 und N22 für den Strom im Gegenkopplungsstromkreis 217 einen Hochpass erster Ordnung mit der Grenzfrequenz f_{g} bildet. Da in diesem Fall an dem Widerstand 210 eine beträchtlich höhere Spannung abfällt als an einem niederohmigen Strommesswiderstand, wird die Signalverarbeitungen in den weiteren Stufen einfach und wenig störanfällig.

Nach einer besonderen konstruktiven Ausbildung ist vorgesehen, dass die primären Wicklungen der aktiven Leiter beider Stromwandler 11 und 12 gemeinsame Wicklungen um beide Stromwandlerkerne sind, dass eine erste Sekundärwicklung N13 des ersten Stromwandlers 11 als separate Wicklung für die Schwingschaltung ausgebildet ist und dass die Sekundärwicklung N22 des zweiten Stromwandlers 12 und eine zweite Sekundärwicklung N12 des ersten Stromwandlers 11 eine gemeinsame Wicklung sind. Hierdurch ist die erforderliche Phasendrehung für eine gegenkoppelnde Wirkung des Stromes aus der Wicklung N22 des zweiten Stromwandlers 12 auf den ersten Stromwandler 11 mit einfachen passiven Zweipolen als Koppelglied gegeben. Durch das Zusammenführen dieser Wicklungen ist eine kompakte Ausbildung der erfindungsgemäßen Vorrichtung möglich.

In einer besonders vorteilhaften konstruktiven Ausgestaltung ist vorgesehen, dass der Kern des ersten Stromwandlers 11 und der Kern des zweiten Stromwandlers 12 in einem als Schutztrog ausgebildeten Gehäuse angeordnet sind. Beide Kerne tragen somit insbesondere bei dem Unterspannungsfall zur Ausbildung einer größeren Induktivität bei, um eine hilfsspannungsunabhängige Auslösung bei Wechsel- und Pulsdifferenzströmen zu bewirken.

Die Blockschaltbilder in den Figuren 4, 5, 6, 7 zeigen zwei elektrische zu überwachende Stromleiter 21, die als Primärwicklungen N11a und N11b und N21a und N22a zweier magnetischer Stromwandler 11 und 12 ausgeführt sind. Der erste Stromwandler 11 weist zwei voneinander getrennte Sekundärwicklungen N13 und N12 auf. Die erste Sekundärwicklung N13 ist dabei zusammen mit der Schaltung 22 eine als Rechteckgenerator ausgebildete Schwingschaltung. Der Rechteckgenerator ist mit dem Tiefpass 23 verschaltet, dem als Teil einer Auswerteeinrichtung 216 der Summierverstärker 24 mit nachfolgendem Zweiweggleichrichter 25 im Leitungsweg nachfolgt. Die zweite Sekundärwicklung N12 des ersten Stromwandlers 11 sowie die Sekundärwicklung N22 des zweiten Stromwandlers 12 sind über ein Schaltelement 28 mit dem in Reihe angeordneten Koppelglied 29 und Strommesswiderstand 210 verschaltet. Der Strommesswiderstand 210 ist über die zweite Auswerteschaltung 211 gleichfalls mit dem Summierverstärker 24 verknüpft. Die in dem Summierverstärker 24 zusammengefassten Signale werden über einen Zweiweggleichrichter 25 und dem nachfolgenden Tiefpass 26 der Komparatorschaltung 27 zugeführt. Diese Komparatorschaltung 27 ist mit dem Auslöserelais 213 verknüpft. Der Schaltkontakt 28 im Stromkreis der Sekundärwicklungen N12 und N22 steht mit dem Unterspannungsdetektor 214 in seine Schaltung bewirkender Wechselwirkung. Das Blockschaltbild in Fig.7 zeigt den Zustand bei Vorlage einer Unterspannung. In diesem Fall sind die Sekundärwicklungen N12 und N22 beider Stromwandler 11 und 12 über die elektrische Anpassschaltung 212 direkt mit dem Auslöserelais 213 verknüpft. Eine Netzteilschaltung 215, welche aus den elektrischen zu überwachenden Stromleitern 21 gespeist wird, versorgt die hilfsspannungsabhängigen Baugruppen 22, 23, 24, 25, 26, 27, 211 und 214 mit einer erforderlichen Gleichspannung. Die Darstellung in den Figuren 4, 5, 6, 7 mit zwei zu überwachenden Stromleitern 21 schließt auch Ausführungen mit ein, die mehr als zwei zu überwachende Stromleiter 21 aufweisen.

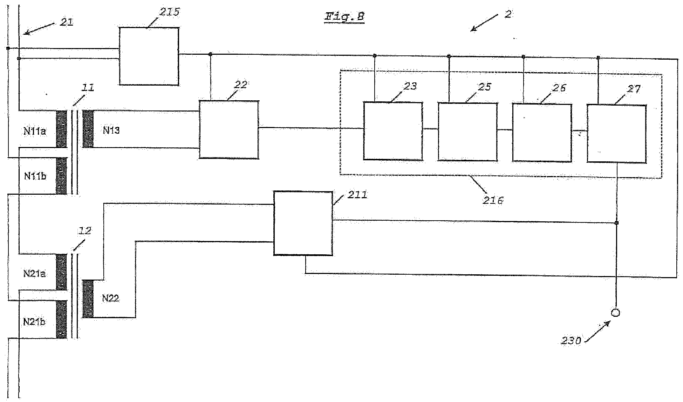

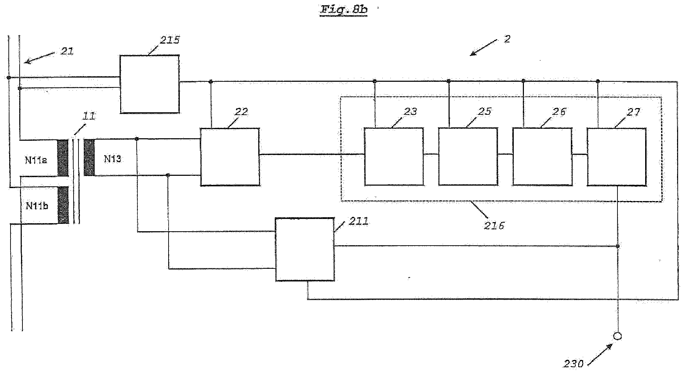

Figur 8 zeigt ein erfindungsgemäßes Differenzstrom-Überwachungsgerät zur Verwendung in Gleichstromsystemen. Das Differenzstrom-Überwachungsgerät 2 ist zur Erfassung und Auswertung von glatten und pulsierenden Differenzströmen sowie Wechseldifferenzströmen mit den gleichen Komponenten wie die in Figur 5 dargestellte erfindungsgemäße Fehlerstrom-Schutzeinrichtung 2 ausgebildet. Es wird an dieser Stelle bezüglich der Beschreibung in vereinfachter Weise auf Figur 5 und Figur 5b verwiesen. Wie bereits weiter oben erwähnt werden Differenzstrom-Überwachungsgeräte (RCM)s vorrangig für Überwachungs- und nicht für Schutzzwecke eingesetzt und weisen üblicherweise keine integrierten Mittel zur Abschaltung von zu überwachenden Stromleitungen auf. Die in Figur 5 dargestellten Komponenten 213, 218, 219, 220, 221 sind nicht erforderlich. Wie in Figur 8 dargestellt sind die erste Auswerteschaltung 216 und die zweite Auswerteschaltung 211 ausgangsseitig mit einem Ausgang 230 verbunden. Der Ausgang 230 kann ein Signal in elektrischer, akustischer oder optischer Weise bereitstellen, wenn ein zulässiger Wert des erfassten Differenzstromes überschritten wird.

Figur 8b zeigt eine weitere Ausgestaltung des erfindungsgemäßen Differenzstrom-Überwachungsgerätes. Die zweite Auswerteschaltung 211 ist eingangsseitig parallel zur Eingangsseite der ersten Auswerteschaltung 216 verschaltet. Die zweite Auswerteschaltung 211 ist somit eingangsseitig mit der Sekundärwicklung N13 des ersten Stromwandlers 11 verschaltet. Auf den zweiten Stromwandler 12 kann daher in vorteilhafter Weise verzichtet werden. Auch mit einem so ausgeführten erfindungsgemäßen Differenzstrom-Überwachungsgerät 2 lassen sich in vorteilhafter Weise neben glatten Gleichfehlerströmen auch pulsierende Gleichfehlerströme und Wechselfehlerströme mit Frequenzen bis zu einigen kHz sicher erfassen.

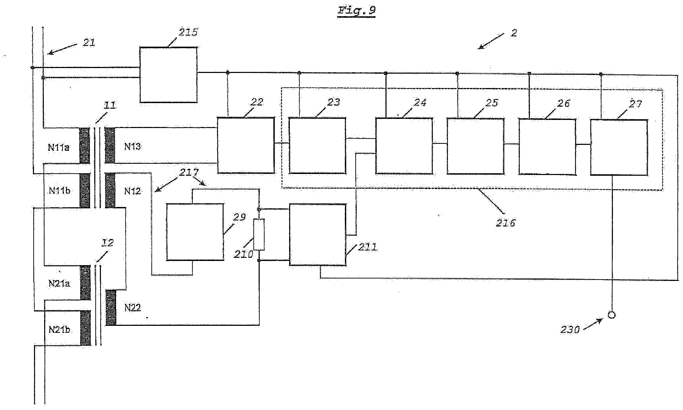

Figur 9 zeigt eine Weiterbildung des erfindungsgemäßen Differenzstrom-Überwachungsgerätes zur Verwendung in Gleichstromsystemen. Die Weiterbildung des Differenzstrom-Überwachungsgerätes 2 ist zur Erfassung und Auswertung von glatten und pulsierenden Differenzströmen sowie Wechseldifferenzströmen, deren Frequenzanteile größer sind als die Hälfte der Schwingfrequenz der als Oszillator ausgebildeten Schaltung 22, mit den gleichen Komponenten wie die in Figur 6 dargestellte erfindungsgemäße Fehlerstrom-Schutzeinrichtung 2 ausgebildet. Es wird an dieser Stelle bezüglich der Beschreibung in vereinfachter Weise auf Figur 6 verwiesen. Wie bereits weiter oben erwähnt werden Differenzstrom-Überwachungsgeräte (RCM)s vorrangig für Überwachungs- und nicht für Schutzzwecke eingesetzt und weisen üblicherweise keine integrierten Mittel zur Abschaltung von zu überwachenden Stromleitungen auf. Die in Figur 6 dargestellten Komponenten 213, 218, 219, 220, 221 sind nicht erforderlich. Wie in Figur 9 dargestellt ist die erste Auswerteschaltung 216 ausgangsseitig mit einem Ausgang 230 verbunden. Der Ausgang 230 kann ein Signal in elektrischer, akustischer oder optischer Weise bereitstellen, wenn ein zulässiger Wert des erfassten Differenzstromes überschritten wird.

## Patentansprüche

1. Vorrichtung zur Erfassung und Auswertung von Differenzströmen in gleichstromgespeisten elektrischen Anlagen (1) mit wenigstens zwei Stromleitungen (21) für zu überwachende Lastströme, mit einer Auswerteschaltung (216) zur Auswertung von elektrischen glatten Gleichdifferenzströmen und mit einem Stromwandler (11) zur Erfassung von glatten Gleichdifferenzströmen, durch den die Stromleitungen (21) für die zu überwachenden Lastströme geführt sind, wobei zumindest eine Sekundärwicklung (N13) des Stromwandlers (11) mit einer oszillierenden Schaltung (22) zur Erfassung der glatten Gleichdifferenzströme elektrisch verbunden ist und die oszillierende Schaltung (22) mit der zur Auswertung von glatten Gleichdifferenzströmen vorgesehenen Auswerteschaltung (216) elektrisch verschaltet ist,
**dadurch gekennzeichnet,**
**dass** Mittel zur Auswertung von Differenzströmen mit Wechselanteilen unterschiedlichster Frequenz und von pulsierenden Gleichdifferenzströmen vorgesehen sind, wobei diese Mittel zumindest eine zweite Auswerteschaltung (211) aufweisen, welche eingangsseitig zumindest mit einer Sekundärwicklung (N13) des Stromwandlers (11) elektrisch verschaltet ist.

2. Vorrichtung nach Anspruch 1 **dadurch gekennzeichnet, dass** Mittel zur Erfassung von Differenzströmen mit Wechselanteilen unterschiedlichster Frequenz und von pulsierenden Gleichdifferenzströmen vorgesehen sind, wobei diese Mittel zumindest einen zweiten Stromwandler (12) zur Erfassung dieser Differenzströme aufweisen, durch den die wenigstens zwei Stromleitungen (21) für die zu überwachenden Lastströme geführt sind, wobei der zweite Stromwandler (12) elektrisch leitend mit dem ersten Stromwandler (11) verschaltet ist.

3. Vorrichtung nach Anspruch 1 oder 2 **dadurch gekennzeichnet, dass** sie als Fehlerstrom-Schutzeinrichtung, RCD, mit Mitteln (219) zur Abschaltung von Gleichströmen als Lastströme im Fehlerfall oder als Differenzstrom-Überwachungsgerät, RCM, mit Mitteln (230) zur Meldung von unzulässig hohen Differenzströmen ausgestaltet ist.

4. Vorrichtung nach einem der vorhergehenden Ansprüchen **dadurch gekennzeichnet, dass** eine erste Schaltung zur Erfassung und Auswertung von Gleichdifferenzströmen und Wechseldifferenzströmen bis zu einer Frequenz fg vorgesehen ist und eine zweite Schaltung zur Erfassung und Auswertung von Wechseldifferenzströmen größer einer Grenzfrequenz fg vorgesehen ist.

5. Vorrichtung nach Anspruch 4 **dadurch gekennzeichnet, dass** die erste Schaltung einen ersten Stromwandler (11) und eine mit dem ersten Stromwandler (11) elektrisch verschaltete erste Auswerteschaltung (216) aufweist und dass die zweite Schaltung einen zweiten Stromwandler (12) und eine mit dem zweiten Stromwandler (12) elektrisch verschaltete zweite Auswerteschaltung (211) aufweist.

6. Vorrichtung nach einem der vorhergehenden Ansprüche 2 bis 5 **dadurch gekennzeichnet, dass** auf dem Leitungsweg (217) zwischen der Stromwandlern (11, 12) ein eine Phasendrehung des über den Leitungsweg (217) geführten Stromes um etwa 180° bewirkendes Koppelglied (29) angeordnet ist, das als Hochpass ausgebildet ist.

7. Vorrichtung nach Anspruch 6, **dadurch gekennzeichnet, dass** das als Hochpass ausgebildete Koppelglied (29) zumindest aus einem elektrisch leitenden Draht mit jeweils wenigstens einer gleichsinnigen Windung um den ersten und zweiten Stromwandler (11, 12) ausgebildet ist.

8. Vorrichtung nach Anspruch 7, **dadurch gekennzeichnet, dass** im Verlauf des Drahtes eine Induktivität oder ein ohmscher Widerstand angeordnet ist, so dass ein Tiefpassfilter mit einer oberen Grenzfrequenz fgo ausgebildet ist.

9. Vorrichtung nach einem der vorhergehenden Ansprüche 2 bis 8, **dadurch gekennzeichnet, dass** der erste Stromwandler (11) eine Sekundärwicklung (N12) aufweist und dass der zweite Stromwandler (12) eine Sekundärwicklung (N22) aufweist, welche elektrisch in Reihe mit der Sekundärwicklung (N12) zur Gegenkopplung höherfrequenter Differenzstromanteile auf den ersten Stromwandler (11) verschaltet ist, wobei der erste Stromwandler (11) mit einer Sekundärwicklung (N13) und eine mit einer ersten Auswerteschaltung (216) verknüpfte Schaltung (22) Bestandteile einer modulierenden Schwingschaltung zur Detektierung niederfrequenter Differenzstromanteile sind und dass auf dem Leitungsweg (217) zwischen den Stromwandlern (11, 12) ein Strommesswiderstand (210) zur Detektierung höherfrequenter Differenzstromanteile angeordnet ist.

10. Vorrichtung nach Anspruch 9, **dadurch gekennzeichnet, dass** der Strommesswiderstand (210) elektrisch mit einer zweiten Auswerteschaltung (211) verschaltet ist.

11. Vorrichtung nach Anspruch 10, **dadurch gekennzeichnet, dass** die zweite Auswerteschaltung (211) zumindest eine Verzögerungsschaltung zur Ansprechverzögerung von höherfrequenten Differenzstromspektralanteilen aufweist.

12. Vorrichtung nach einem der vorhergehenden Ansprüche 2 bis 11, **dadurch gekennzeichnet, dass** die wenigstens zwei primären Wicklungen (N11a, N21a, N11b, N21b) aller aktiven Leiter beider Stromwandler (11, 12) gemeinsame Wicklungen um die magnetischen Kerne beider Stromwandler (11, 12) sind und dass die Sekundärwicklung (N22) des zweiten Stromwandlers (12) und eine zweite Sekundärwicklung (N12) des ersten Stromwandlers (11) eine gemeinsame Wicklung um beide magnetischen Kerne beider Stromwandler (11, 12) ist.

13. Vorrichtung nach einem der vorhergehenden Ansprüche 2 bis 12, **dadurch gekennzeichnet, dass** die aus der Schaltung (22) und der Sekundärwicklung (N13) des ersten Stromwandlers (11) gebildete Schwingschaltung als Rechteckgenerator ausgebildet ist.

14. Vorrichtung nach Anspruch 13, **dadurch gekennzeichnet, dass** der Schaltung (22) zumindest ein Tiefpassfilter (23) zur Demodulation nachgeordnet ist.

15. Vorrichtung nach Anspruch 14, **dadurch gekennzeichnet, dass** das Tiefpassfilter (23) als aktives Tiefpassfilter mit einer Welligkeit im Durchlassbereich größer 0 dB und einer Filterordnung größer 1 ausgebildet ist.

16. Vorrichtung nach einem der vorhergehenden Ansprüche, **dadurch gekennzeichnet, dass** die erste Auswerteeinrichtung (216) einen Summierverstärker (24) mit nachfolgendem Zweiweggleichrichter (25) umfasst, wobei der Summierverstärker (24) verschiedene Auslöseschwellen für beide erfassten Differenzstromanteile der Schaltung (22) und der zweiten Auswerteschaltung (211) aufweist.

17. Vorrichtung nach Anspruch 16, **dadurch gekennzeichnet, dass** dem Zweiweggleichrichter (25) zumindest eine Komparatorschaltung (27) nachgeordnet ist.

18. Vorrichtung nach Anspruch 17, **dadurch gekennzeichnet, dass** im Leitungsweg zwischen dem Zweiweggleichrichter (25) und der Komparatorschaltung (27) zumindest ein Tiefpassfilter (26) angeordnet ist.

19. Vorrichtung nach Anspruch 17 oder 18, **dadurch gekennzeichnet, dass** die Komparatorschaltung (27) zwei nacheinander geschaltete Komparatoren aufweist, wobei dem zweiten Komparator ein Tiefpass zugeordnet ist.

20. Vorrichtung nach einem der Ansprüche 17 bis 19, **dadurch gekennzeichnet, dass** die Komparatorschaltung (27) mit wenigstens einem Auslöserelais (213) verknüpft ist.

21. Vorrichtung nach Anspruch 20, **dadurch gekennzeichnet**, das das Auslöserelais (213) mit der Sekundärwicklung (N22) des zweiten Stromwandlers (12), welche mit einer Sekundärwicklung (N12) des ersten Stromwandlers (11) elektrisch in Reihe verschaltet ist, verknüpfbar ist, wobei die Verknüpfung über einen Schaltkontakt (28) vorgenommen ist, welcher von zumindest einem Unterspannungsdetektor (214) in schaltender Weise beaufschlagt ist.

22. Vorrichtung nach Anspruch 21, **dadurch gekennzeichnet, dass** im Leitungsweg zwischen Schaltkontakt (28) und Auslöserelais (213) eine passive elektrische Anpassschaltung (212) angeordnet ist.

23. Vorrichtung nach Anspruch 22, **dadurch gekennzeichnet, dass** die elektrische Anpassschaltung (212) in Verbindung mit der Sekundärwicklung (N22) des zweiten Stromwandlers (12) und der dazu elektrisch in Reihe verschalteten zweiten Sekundärwicklung (N12) des ersten Stromwandlers (11) und mit dem Auslöserelais (213) einen elektrischen Reihen- und Parallelschwingkreis ausbildet.

24. Vorrichtung nach einem der vorhergehenden Ansprüche 6 bis 23, **dadurch gekennzeichnet, dass** die Induktivität des zweiten Stromwandlers (12) wenigstens den zweifachen Wert der Induktivität des ersten Stromwandlers (11) aufweist.

25. Vorrichtung nach einem der vorhergehenden Ansprüche 6 bis 24, **dadurch gekennzeichnet, dass** der magnetische Kern des ersten Stromwandlers (11) und der magnetische Kern des zweiten Stromwandlers (12) in einem gemeinsamen als Schutztrog ausgebildeten Gehäuse angeordnet sind.

26. Vorrichtung nach einem der vorhergehenden Ansprüche 6 bis 25, **dadurch gekennzeichnet, dass** der magnetische Kern des ersten Stromwandlers (11) aus nanokristallinem oder amorphem Werkstoff gebildet ist.

27. Vorrichtung nach einem der vorhergehenden Ansprüche, **dadurch gekennzeichnet, dass** sie zur Verwendung in gleichstromgespeisten elektrischen Anlagen vorgesehen ist.

## Claims

1. Device for detecting and evaluating differential currents in electrical systems (1) supplied with direct current, comprising at least two electric lines (21) for load currents to be monitored, an evaluation circuit (216) for evaluating electric smooth direct differential currents, and a current transformer (11) for detecting smooth direct differential currents through which the electric lines (21) for the load currents to be monitored are guided, wherein at least one secondary winding (N13) of the current transformer (11) is electrically connected to an oscillating circuit (22) for detecting the smooth direct differential currents and the oscillating circuit (22) is electrically connected to the evaluation circuit (216) provided for evaluating smooth direct differential currents, **characterized in that** means are provided for evaluating differential currents with alternating components of very different frequencies as well as pulsating direct differential currents, wherein these means have at least one second evaluation circuit (211) electrically connected on the input side at least to a secondary winding (N13) of the current transformer (11).

2. The device according to claim 1, **characterized in that** means for detecting differential currents with alternating components of very different frequencies as well as pulsating direct differential currents are provided, wherein these means have at least one second current transformer (12) for detecting these differential currents through which the at least two electric lines (21) for the load currents to be monitored are guided, wherein the second current transformer (12) is connected to the first current transformer (11) in an electrically conductive manner.

3. The device according to claim 1 or 2, **characterized in that** it is designed as a residual current device, RCD, with means (219) for switching off load currents in the form of direct currents in the event of a fault, or as a differential-current monitoring device, RCM, with means (230) for signalling unacceptably high differential currents.

4. The device according to one of the preceding claims, **characterized in that** a first circuit is provided for detecting and evaluating direct differential currents and alternating differential currents up to a frequency fg and a second circuit is provided for detecting and evaluating alternating differential currents greater than a limit frequency fg.

5. The device according to claim 4, **characterized in that** the first circuit comprises a first current transformer (11) and a first evaluation circuit (216) electrically connected to the first current transformer (11), and **in that** the second circuit comprises a second current transformer (12) and a second evaluation circuit (211) electrically connected to the second current transformer (12).

6. The device according to one of the preceding claims 2 to 5, **characterized in that** a coupling element (29) designed as a high-pass filter and causing a phase rotation of the current conducted over the conduction path (217) by approximately 180° is arranged on the conduction path (217) between the current transformers (11, 12).

7. The device according to claim 6, **characterized in that** the coupling element (29) designed as a high-pass filter is formed at least from an electrically conductive wire with respectively at least one winding running in the same direction around the first and second current transformers (11, 12).

8. The device according to claim 7, **characterized in that** an inductor or an ohmic resistor is arranged along the wire so as to form a low-pass filter with an upper limit frequency fgo.

9. The device according to one of the preceding claims 2 to 8, **characterized in that** the first current transformer (11) has a secondary winding (N12) and **in that** the second current transformer (12) has a secondary winding (N22), which is electrically connected in series with the secondary winding (N12) for feedback of higher-frequency differential current components to the first current transformer (11), wherein the first current transformer (11) with a secondary winding (N13) and a circuit (22) linked to a first evaluation circuit (216) are components of a modulating oscillating circuit for detecting lowfrequency differential current components, and **in that** a current-measuring resistor (210) for detecting higher-frequency differential current components is arranged on the conduction path (217) between the current transformers (11, 12).

10. The device according to claim 9, **characterized in that** the current-measuring resistor (210) is electrically connected to a second evaluation circuit (211).

11. The device according to claim 10, **characterized in that** the second evaluation circuit (211) comprises at least one delay circuit for the response delay of higher-frequency differential-current spectral components.

12. The device according to one of the preceding claims 2 to 11, **characterized in that** the at least two primary windings (N11a, N21a, N11b, N21b) of all active conductors of both current transformers (11, 12) are common windings around the magnetic cores of both current transformers (11, 12) and **in that** the secondary winding (N22) of the second current transformer (12) and a second secondary winding (N12) of the first current transformer (11) are a common winding around both magnetic cores of both current transformers (11, 12).

13. The device according to one of the preceding claims 2 to 12, **characterized in that** the oscillating circuit formed by the circuit (22) and the secondary winding (N13) of the first current transformer (11) is designed as a square-wave generator.

14. The device according to claim 13, **characterized in that** at least one low-pass filter (23) for demodulation is arranged downstream of the circuit (22) .

15. The device according to claim 14, **characterized in that** the low-pass filter (23) is designed as an active low-pass filter with a ripple in the pass band greater than 0 dB and a filter order greater than 1.

16. The device according to one of the preceding claims, **characterized in that** the first evaluation device (216) comprises a summing amplifier (24) followed by a two-way rectifier (25), wherein the summing amplifier (24) has different trigger thresholds for both detected differential current components of the circuit (22) and of the second evaluation circuit (211).

17. The device according to claim 16, **characterized in that** at least one comparator circuit (27) is arranged downstream of the two-way rectifier (25).

18. The device according to claim 17, **characterized in that** at least one low-pass filter (26) is arranged in the conduction path between the two-way rectifier (25) and the comparator circuit (27).

19. The device according to claim 17 or 18, **characterized in that** the comparator circuit (27) comprises two comparators connected in series, wherein a low-pass filter is associated with the second comparator.

20. The device according to one of claims 17 to 19, **characterized in that** the comparator circuit (27) is linked to at least one trigger relay (213).

21. The device according to claim 20, **characterized in that** the trigger relay (213) can be linked to the secondary winding (N22) of the second current transformer (12), which is electrically connected in series with a secondary winding (N12) of the first current transformer (11), wherein the link is provided via a switch contact (28) to which current is applied by at least one undervoltage detector (214) in a switching manner.

22. The device according to claim 21, **characterized in that** a passive electrical matching circuit (212) is arranged in the conduction path between the switch contact (28) and the trigger relay (213).

23. The device according to claim 22, **characterized in that** the electrical matching circuit (212) forms, in conjunction with the secondary winding (N22) of the second current transformer (12) and the second secondary winding (N12) of the first current transformer (11) electrically connected in series thereto as well as the trigger relay (213), an electrical series and parallel resonant circuit.

24. The device according to one of the preceding claims 6 to 23, **characterized in that** the inductance of the second current transformer (12) is at least twice the value of the inductance of the first current transformer (11).

25. The device according to one of the preceding claims 6 to 24, **characterized in that** the magnetic core of the first current transformer (11) and the magnetic core of the second current transformer (12) are arranged in a common housing designed as a protective trough.

26. The device according to one of the preceding claims 6 to 25, **characterized in that** the magnetic core of the first current transformer (11) is formed of nanocrystalline or amorphous material.

27. The device according to one of the preceding claims, **characterized in that** it is intended for use in electrical systems powered by direct current.

## Revendications

1. Dispositif de détection et d'évaluation de courants différentiels dans des installations électriques (1) alimentées en courant continu, avec au moins deux lignes électriques (21) pour les courants de charge à surveiller, un circuit d'évaluation (216) pour l'évaluation de courants électriques différentiels continus lisses, et un transformateur de courant (11) pour détecter les courants différentiels continus lisses à travers lequel sont acheminées les lignes électriques (21) pour les courants de charge à surveiller, dans lequel au moins un enroulement secondaire (N13) du transformateur de courant (11) est connecté électriquement à un circuit oscillant (22) pour détecter les courants différentiels continus lisses, et le circuit oscillant (22) est connecté électriquement au circuit d'évaluation (216) pourvu pour évaluer les courants différentiels continus lisses, **caractérisé en ce que** des moyens sont pourvus pour évaluer les courants différentiels à composantes alternatives de fréquences très différentes et les courants différentiels continus pulsés, dans lequel ces moyens comportent au moins un deuxième circuit d'évaluation (211) qui est connecté électriquement côté entrée à au moins un enroulement secondaire (N13) du transformateur de courant (11).

2. Dispositif selon la revendication 1, **caractérisé en ce que** sont pourvus des moyens de détection de courants différentiels à composantes alternatives de fréquences très différentes et de courants différentiels continus pulsés, dans lequel ces moyens comportent au moins un deuxième transformateur de courant (12) pour détecter ces courants différentiels, à travers lequel sont acheminées lesdites au moins deux lignes électriques (21) pour les courants de charge à surveiller, dans lequel le deuxième transformateur de courant (12) est connecté électriquement au premier transformateur de courant (11).

3. Dispositif selon la revendication 1 ou 2, **caractérisé en ce qu'**il est constitué comme un dispositif différentiel à courant résiduel, DDR, avec des moyens (219) pour couper les courants continus comme courants de charge en cas de défaut, ou comme un moniteur de courant différentiel, MCR, avec des moyens (230) pour signaler des courants différentiels inadmissiblement élevés.

4. Dispositif selon l'une des revendications précédentes, **caractérisé en ce qu'**un premier circuit est pourvu pour détecter et évaluer des courants différentiels continus et des courants différentiels alternatifs jusqu'à une fréquence fg, et **en ce qu'**un deuxième circuit est pourvu pour détecter et évaluer les courants différentiels alternatifs supérieurs à une fréquence seuil fg.

5. Dispositif selon la revendication 4, **caractérisé en ce que** le premier circuit comporte un premier transformateur de courant (11) et un premier circuit d'évaluation (216) connecté électriquement au premier transformateur de courant (11), et **en ce que** le deuxième circuit comporte un deuxième transformateur de courant (12) et un deuxième circuit d'évaluation (211) connecté électriquement au deuxième transformateur de courant (12).

6. Dispositif selon l'une des revendications précédentes 2 à 5, **caractérisé en ce qu'**un élément de couplage (29) provoquant une rotation de phase du courant conduit via le chemin de ligne (217) d'environ 180° est agencé sur le chemin de ligne (217) entre les transformateurs de courant (11, 12), l'élément de couplage étant constitué comme un filtre passe-haut.

7. Dispositif selon la revendication 6, **caractérisé en ce que** l'élément de couplage (29) conçu comme un filtre passe-haut est constitué d'au moins un fil électroconducteur comportant chaque fois au moins un enroulement dans le même sens autour des premier et deuxième transformateurs de courant (11, 12).

8. Dispositif selon la revendication 7, **caractérisé en ce qu'**une inductance ou une résistance ohmique est agencée sur le parcours du fil, de manière à constituer un filtre passe-bas avec une fréquence seuil supérieure fgo.

9. Dispositif selon l'une des revendications précédentes 2 à 8, **caractérisé en ce que** le premier transformateur de courant (11) comporte un enroulement secondaire (N12) et le deuxième transformateur de courant (12) comporte un enroulement secondaire (N22) qui est connecté électriquement en série avec l'enroulement secondaire (N12) pour une contre-réaction des composantes de courant différentiel à haute fréquence sur le premier transformateur de courant (11), dans lequel le premier transformateur de courant (11) comportant un enroulement secondaire (N13) et un circuit (22) relié à un premier circuit d'évaluation (216) sont des composants d'un circuit oscillant modulant destiné à détecter les composantes de courant différentiel à basse fréquence, et **en ce que**, sur le chemin de ligne (217) entre les transformateurs de courant (11, 12), est agencée une résistance de mesure de courant (210) destinée à détecter les composants de courant différentiel à haute fréquence.

10. Dispositif selon la revendication 9, **caractérisé en ce que** la résistance de mesure de courant (210) est connectée électriquement à un deuxième circuit d'évaluation (211).

11. Dispositif selon la revendication 10, **caractérisé en ce que** le deuxième circuit d'évaluation (211) comporte au moins un circuit de temporisation pour temporiser la réponse de composantes spectrales de courant différentiel à haute fréquence.

12. Dispositif selon l'une des revendications précédentes 2 à 11, **caractérisé en ce que** lesdits au moins deux enroulements primaires (N11a, N21a, N11b, N21b) de tous les conducteurs actifs des deux transformateurs de courant (11, 12) sont des enroulements communs autour des noyaux magnétiques des deux transformateurs de courant (11, 12), et **en ce que** l'enroulement secondaire (N22) du deuxième transformateur de courant (12) et un deuxième enroulement secondaire (N12) du premier transformateur de courant (11) sont un enroulement commun autour des deux noyaux magnétiques des deux transformateurs de courant (11, 12).

13. Dispositif selon l'une des revendications précédentes 2 à 12, **caractérisé en ce que** le circuit oscillant formé par le circuit (22) et l'enroulement secondaire (N13) du premier transformateur de courant (11) est constitué comme un générateur de créneaux.

14. Dispositif selon la revendication 13, **caractérisé en ce qu'**au moins un filtre passe-bas (23) de démodulation est agencé en aval du circuit (22).

15. Dispositif selon la revendication 14, **caractérisé en ce que** le filtre passe-bas (23) est constitué sous la forme d'un filtre passe-bas actif avec une ondulation dans la bande passante supérieure à 0 dB et un ordre de filtrage supérieur à 1.

16. Dispositif selon l'une des revendications précédentes, **caractérisé en ce que** le premier dispositif d'évaluation (216) comporte un amplificateur sommateur (24) suivi d'un redresseur double alternance (25), dans lequel l'amplificateur sommateur (24) comporte des seuils de déclenchement différents pour les deux composantes de courant différentiel détectées du circuit (22) et du deuxième circuit d'évaluation (211) .

17. Dispositif selon la revendication 16, **caractérisé en ce qu'**au moins un circuit comparateur (27) est agencé en aval du redresseur double alternance (25).

18. Dispositif selon la revendication 17, **caractérisé en ce qu'**au moins un filtre passe-bas (26) est agencé dans le chemin de ligne entre le redresseur double alternance (25) et le circuit comparateur (27).

19. Dispositif selon la revendication 17 ou 18, **caractérisé en ce que** le circuit comparateur (27) comporte deux comparateurs connectés en série, dans lequel un filtre passe-bas est associé au deuxième comparateur.

20. Dispositif selon l'une des revendications 17 à 19, **caractérisé en ce que** le circuit comparateur (27) est connecté à au moins un relais de déclenchement (213).

21. Dispositif selon la revendication 20, **caractérisé en ce que** le relais de déclenchement (213) peut être relié à l'enroulement secondaire (N22) du deuxième transformateur de courant (12), qui est connecté électriquement en série à un enroulement secondaire (N12) du premier transformateur de courant (11), dans lequel la liaison s'effectue par l'intermédiaire d'un contact de commutation (28) qui est sollicité de manière commutable par au moins un détecteur de soustension (214).

22. Dispositif selon la revendication 21, **caractérisé en ce qu'**un circuit d'adaptation électrique passif (212) est agencé dans le chemin de ligne entre le contact de commutation (28) et le relais de déclenchement (213).

23. Dispositif selon la revendication 22, **caractérisé en ce que** le circuit électrique d'adaptation (212) constitue un circuit résonnant électrique en série et en parallèle conjointement à l'enroulement secondaire (N22) du deuxième transformateur de courant (12) et au deuxième enroulement secondaire (N12) du premier transformateur de courant (11), qui est connecté électriquement en série à celui-ci, et au relais de déclenchement (213).

24. Dispositif selon l'une des revendications précédentes 6 à 23, **caractérisé en ce que** l'inductance du deuxième transformateur de courant (12) a au moins deux fois la valeur de l'inductance du premier transformateur de courant (11).

25. Dispositif selon l'une des revendications précédentes 6 à 24, **caractérisé en ce que** le noyau magnétique du premier transformateur de courant (11) et le noyau magnétique du deuxième transformateur de courant (12) sont agencés dans un boîtier commun constitué sous forme d'une cuvette de protection.

26. Dispositif selon l'une des revendications précédentes 6 à 25, **caractérisé en ce que** le noyau magnétique du premier transformateur de courant (11) est constitué d'un matériau nanocristallin ou amorphe.

27. Dispositif selon l'une des revendications précédentes, **caractérisé en ce qu'**il est destiné à être utilisé dans des installations électriques alimentées en courant continu.
